# EUROPÄISCHE PATENTSCHRIFT

(11) **EP 3 222 125 B1**
(45) Veröffentlichungstag und Bekanntmachung des Hinweises auf die Patenterteilung: **10.11.2021**
(21) Anmeldenummer: 15771080.7
(22) Anmeldetag: 25.09.2015
(51) Int. Cl.: H05K 1/14, H05K 5/00, H05K 3/28

(54) **GETRIEBESTEUERMODUL FÜR DEN EINSATZ IN EINEM KONTAMINIERENDEN MEDIUM UND VERFAHREN ZUR HERSTELLUNG EINES SOLCHEN GETRIEBESTEUERMODULES**
TRANSMISSION CONTROL MODULE FOR USE IN A CONTAMINATING MEDIUM AND METHOD FOR PRODUCING SUCH A TRANSMISSION CONTROL MODULE
MODULE DE COMMANDE DE TRANSMISSION POUR UNE UTILISATION DANS UN MILIEU CONTAMINANT ET PROCÉDÉ DE FABRICATION D'UN TEL MODULE DE COMMANDE DE TRANSMISSION

(30) Priorität: 21.11.2014 DE 102014223835
(43) Veröffentlichungstag der Anmeldung: 27.09.2017
(73) Patentinhaber: Robert Bosch GmbH, 70442 Stuttgart (DE)
(72) Erfinder: LISKOW, Uwe, 71679 Asperg (DE)
(86) Internationale Anmeldenummer: PCT/EP2015/072057
(87) Internationale Veröffentlichungsnummer: WO 2016/078806

(56) Entgegenhaltungen:
- EP-A1- 3 186 828
- DE-A1-102010 026 953
- DE-A1-102011 085 170
- DE-A1-102011 085 172

## Beschreibung

### Stand der Technik

Die Erfindung betrifft ein Getriebesteuermodul für den Einsatz in einem kontaminierenden Medium, eine TCU-Baugruppe zur Verwendung in einem solchen Getriebesteuermodul und ein Verfahren zur Herstellung eines solchen Getriebesteuermodules.

Es ist bekannt, in der Kraftfahrzeugtechnik Getriebesteuermodule zu verwenden, die am Getriebe und im Getriebefluid eingesetzt werden können. Diese Getriebesteuermodule, die auch kurz als "Module" bezeichnet werden, können beispielsweise elektrische Komponenten wie Stecker, Sensoren, Aktuatoren, eine elektronische Schaltung (TCU, Transmission Control Unit) und gegebenenfalls weitere Komponenten aufweisen. Die Anordnung des Getriebesteuermoduls im Getriebefluid stellt hohe Herausforderungen an den Gesamtaufbau des Getriebesteuermodules, da die Komponenten und elektrischen Verbindungen vor dem kontaminierenden Getriebefluid mit darin gegebenenfalls enthaltenen Metallspänen geschützt werden müssen.

Bekannte Getriebesteuermodule der neueren Produktgenerationen verwenden einen Aufbau mit einem dem Getriebefluid ausgesetzten Leiterbahnsubstrat (sogenannte Modul-AVT, Aufbau und Verbindungstechnik), das auf eine Trägerplatte aufgebracht wird. Als Leiterbahnsubstrat kommen neben flexiblen Leiterbahnfolien und umspritzten Stanzgittern auch zunehmend konventionell hergestellte starre Leiterplatten aus faserverstärktem Epoxidharz zum Einsatz, die Leiterbahnen in mehreren Ebenen aufweisen können. Die Leiterbahnen des Leiterbahnsubstrats dienen zur Herstellung der elektrischen Verbindungen zwischen der zentralen elektronischen Schaltung und den übrigen Komponenten des Getriebesteuermoduls, also den Steckern, Sensoren und Aktuatoren. Das Leiterbahnsubstrat weist eine durchgehende Ausnehmung auf, in die eine TCU-Leiterplatte, die mit elektrischen Bauelementen der zentralen Steuerschaltung bestückt ist, eingesetzt und auf die Trägerplatte beispielsweise durch Kleben aufgebracht wird. Derartige Getriebesteuermodule sind beispielsweise aus der DE 10 2004 061 818 A1 bekannt, welche den Aufbau mit einer flexiblen Leiterbahnfolie zeigt, oder aus der DE 10 2011 089 474 A1, welche in der dortigen Fig. 1 den Aufbau mit einer starren konventionellen Leiterplatte als Leiterbahnsubstrat zeigt. Die elektrischen Verbindungen zwischen der TCU-Leiterplatte und dem Leiterbahnsubstrat werden beispielsweise über Bonddrähte hergestellt.

Auf der TCU-Leiterplatte sind elektrische Bauelemente, wie Mikrocontroller, Speicher, Leistungsendstufen, Widerstände und Kondensatoren bestückt, um nur einige zu nennen. Aus Bauraumgründen werden für die elektrischen Bauelemente dabei teilweise auch sogenannte "bare-die" Bauelemente verwandt, welche ungehäust sind. Die sogenannten Pitch-Abstände (Mitte-Mitte-Abstände der Bauteilanschlüsse) der elektrischen Bauelemente auf der TCU-Leiterplatte sind sehr klein. Die auf der TCU-Leiterplatte angeordnete Schaltung ist sehr empfindlichen gegenüber Kurzschlüssen durch leitende, kleine Partikel, so dass die TCU-Leiterplatte sorgfältig geschützt werden muss. Hierzu wird in der DE 10 2004 061 818 A1 und der DE 10 2011 089 474 A1 jeweils ein Deckelteil als Abdeckung verwandt, das über der elektronischen Schaltung angeordnet wird und an dem Leiterbahnsubstrat beispielsweise durch Dichtkleben festgelegt wird. Das Deckelteil übergreift also die gesamte TCU-Leiterplatte und die Bonddrahtverbindungen zwischen der TCU-Leiterplatte und dem Leiterbahnsubstrat. Außerdem kann ein Gel zum Schutz der elektrischen Bauelemente in dem Raum unter dem Deckel auf die Schaltung und die Bonddrähte appliziert werden.

Neben diesen Getriebesteuermodultypen sind solche bekannt, wie sie beispielsweise die DE 10 2012 209 033 A1 offenbart. Es handelt sich um eine Ausführungsform, bei welcher die TCU-Leiterplatte mit Moldmasse vollständig ummoldet wird. Anschlussbeinchen sind aus der Moldmasse herausgeführt und mit dem Leiterbahnsubstrat auf der Trägerplatte kontaktiert.

Aus der DE 10 2011 085 170 A1 ist ein Getriebesteuermodul für den Einsatz in einem kontaminierendem Medium bekannt, das eine Trägerplatte und ein auf der Trägerplatte angeordnetes Leiterbahnsubstrat aufweist. Eine TCU-Leiterplatte ist über elektrische Verbindungsmittel mit dem Leiterbahnsubstrat elektrisch kontaktiert. Zum Schutz der TCU-Leiterplatte ist diese in eine Abdeckung aus Moldmasse eingebracht, welche ausschließlich auf der TCU-Leiterplatte angeordnet und befestigt ist. Die DE 10 2011 085 170 A1 offenbart weder, dass die TCU-Leiterplatte auf die Trägerplatte aufgebracht ist, noch dass die TCU-Leiterplatte einen äußeren Bereich aufweist, der nicht von der Abdeckung abgedeckt ist.

Die DE 10 2010 026 953 A1 offenbart eine TCU-Baugruppe, umfassend eine TCU-Leiterplatte, die mit elektrischen Bauelementen einer Steuerschaltung bestückt ist, wobei eine ausschließlich an der TCU-Leiterplatte dicht angeordnete und befestigte Abdeckung aus Moldmasse vorgesehen ist. Die TCU-Leiterplatte ist nicht in eine Aussparung eines Leiterbahnsubstrats eingesetzt und nicht auf eine Trägerplatte aufgebracht.

Die DE 10 2011 085 172 A1 offenbart ein Getriebesteuermodul, bei dem ein über der elektronischen Schaltung angeordnetes Deckelteil, als Abdeckung an dem Leiterbahnsubstrat festgelegt wird. Das Deckelteil übergreift also die gesamte TCU-Leiterplatte und die elektrischen Verbindungen zwischen der TCU-Leiterplatte und dem Leiterbahnsubstrat. Eine Abdeckung zum gemeinsamen Schutz von auf der TCU-Leiterplatte angeordneten elektrischen Bauelementen, wobei die Abdeckung ausschließlich auf der TCU-Leiterplatte dicht angeordnet und befestigt ist, wird nicht offenbart.

Weitere bekannte Getriebesteuermodule verwenden eine TCU-Leiterplatte, die in einem Metallgehäuse hermetisch dicht verkapselt wird. Elektrische Anschlussstifte sind in Glasdurchführungen eingeschmolzen, die im Inneren des Gehäuses mit der TCU-Leiterplatte kontaktiert sind und deren zur Kontaktierung des Leiterbahnsubstrats vorgesehenen Enden aus dem Gehäuse herausgeführt sind.

Die Herstellung bekannter Getriebesteuermodule erfolgt beispielsweise derart, dass die TCU-Leiterplatten mit den darauf jeweils befindlichen elektrischen Steuerschaltungen an speziellen hochentwickelten Fertigungsstandorten hergestellt werden, welche auf die Herstellung derartiger hochintegrierte Schaltungsteile spezialisiert sind. Die dafür benötigten Investitionen in die Fertigung für die bare-die-Bestückung der TCU-Leiterplatte sind nicht unerheblich. Die TCU-Leiterplatten werden dann dicht verpackt, beispielsweise durch die oben erwähnte Verkapselung in metallischen Gehäusen mit Glasdurchführen, an einen anderen Fertigungsstandort verbracht und dort mit dem Leiterbahnsubstrat eines Getriebesteuermodules kontaktiert.

Andere Fertigungsverfahren sehen die Herstellung der TCU-Leiterplatte mit der elektrischen Steuerschaltung am gleichen Standort wie die Fertigung des restlichen Getriebesteuermoduls vor. Dadurch entsteht aber ein kostentreibender Fertigungsverbund, da die komplexe Herstellung der unverpackten Elektroniken am gleichen Ort wie die Herstellung des restlichen Getriebesteuermoduls durchgeführt wird.

### Offenbarung der Erfindung

Die Erfindung betrifft ein Getriebesteuermodul für den Einsatz in einem kontaminierenden Medium nach Anspruch 1.

Erfindungsgemäß wird ein Getriebesteuermodul für den Einsatz in einem kontaminierenden Medium vorgeschlagen, aufweisend:
- eine Trägerplatte,
- ein Leiterbahnsubstrat, das auf der Trägerplatte angeordnet ist und eine durchgehende Ausnehmung aufweist,
- eine TCU-Leiterplatte, die mit elektrischen Bauelementen einer Steuerschaltung bestückt ist und die in die Aussparung des Leiterbahnsubstrats eingesetzt und auf die Trägerplatte aufgebracht ist,
- elektrische Verbindungsmittel, welche die TCU-Leiterplatte mit dem Leiterbahnsubstrat elektrisch kontaktieren,
- und eine Abdeckung zum gemeinsamen Schutz der auf der TCU-Leiterplatte angeordneten elektrischen Bauelemente,
wobei die Abdeckung ausschließlich auf der TCU-Leiterplatte dicht angeordnet und befestigt ist, wobei eine mit den elektrischen Bauelementen bestückte Bestückungsseite der TCU-Leiterplatte einen inneren ersten Bereich aufweist, der von der Abdeckung abgedeckt ist, und einen äußeren zweiten Bereich aufweist, der nicht von der Abdeckung abgedeckt ist, und dass in dem äußeren zweiten Bereich Kontaktstellen zur elektrischen Kontaktierung der TCU-Leiterplatte angeordnet sind, wobei die elektrischen Verbindungsmittel elektrische Kontaktstellen auf einer von der Trägerplatte abgewandten Bestückungsseite der TCU-Leiterplatte mit elektrischen Kontaktstellen auf einer von der Trägerplatte abgewandten Seite des Leiterbahnsubstrats verbinden.

Unter einer dicht auf der TCU-Leiterplatte angeordneten Abdeckung wird dabei eine Anordnung verstanden, bei der die elektrischen Bauelemente zwischen der Abdeckung und der TCU-Leiterplatte gegenüber dem Außenraum geschützt sind, das heißt bei der im Auflagebereich von Abdeckung und TCU-Leiterplatte wenigstens ein umlaufender Dichtbereich geschaffen ist, der verhindert, dass Hydraulikfluid im Auflagebereich zwischen der Abdeckung und der TCU-Leiterplatte in Richtung Bauelemente vordringen kann, wobei dies sowohl unmittelbar durch beispielsweise eine stoffschlüssige Verbindung von Abdeckung und TCU-Leiterplatte erreicht werden kann, wie auch mittelbar durch beispielsweise einen Dichtkleberauftrag zwischen Abdeckung und TCU-Leiterplatte.

Unter einer Abdeckung zum gemeinsamen Schutz der auf der TCU-Leiterplatte angeordneten elektrischen Bauelemente wird im Kontext der vorliegenden Anmeldung die äußerste Abdeckung dieser Bauelemente auf dem Getriebesteuermodul verstanden, gleich welche weiteren abdeckenden Maßnahmen (beispielsweise einen Gelauftrag) unterhalb der Abdeckung und oberhalb der Bauelemente eventuell noch zusätzlich vorgesehen sein können.

### Vorteile der Erfindung

Durch die Erfindung wird vorteilhaft erreicht, dass unter Beibehaltung des bisherigen vorteilhaften Konzepts einer TCU-Leiterplatte, die zur Wärmeableitung der von der elektronischen Schaltung im Betrieb erzeugten Wärme in einer Ausnehmung eines Leiterbahnsubstrats direkt auf der Trägerplatte eines Getriebesteuermoduls angeordnet wird, die Modulfertigung an unterschiedlichen Standorten durchgeführt werden kann. Die Herstellung der TCU-Leiterplatte mit feinen Leiterbahnstrukturen, die Vereinzelung dieser Substrate aus einem Großnutzenverbund und die Bestückung der TCU-Leiterplatte mit einer elektrischen Steuerschaltung, insbesondere die aufwändigen bare-die-Bestückung, können somit an einem dafür spezialisierten Standort durchgeführt werden. Die auf der TCU-Leiterplatte befindliche Steuerschaltung wird nach ihrer Herstellung durch eine Abdeckung geschützt, die direkt auf die Oberfläche der TCU-Leiterplatte aufgebracht wird. Die Abdeckung dichtet die Steuerschaltung nach außen ab. Hierzu kommen unterschiedliche Abdeckungen in Betracht, wie noch ausgeführt wird. Durch die schützende Abdeckung wird die elektronische Steuerschaltung der TCU-Leiterplatte dauerhaft dicht verpackt. Elektrische Anschlüsse der Steuerschaltung befinden sich vorzugsweise im Randbereich der TCU-Leiterplatte außerhalb des durch die Abdeckung geschützten Bereichs. Die fertig bestückte und mit der Abdeckung versehene TCU-Leiterplatte bildet vorteilhaft eine TCU-Baugruppe, die unproblematisch an einen anderen Standort geliefert werden kann. Dabei kann die fertige TCU-Baugruppe vorteilhaft an Standort geliefert werden, welche die bare-die-Fertigung nicht beherrschen brauchen. Teure Transportverpackungen können entfallen, da die elektronische Schaltung durch die ausschließlich auf der TCU-Leiterplatte angeordnete und befestigte hermetische Abdeckung vor Feuchtigkeit und Partikeln gut geschützt ist. An den anderen Standorten wird die TCU-Baugruppe dann einfach mit den übrigen Bestandteilen des Getriebesteuermoduls verbunden. Die anderen Standorte können das Leiterbahnsubstrat und die Trägerplatte preiswert mit speziellen Komponenten, also beispielsweise Stecker, Sensoren oder Aktuatoren bestücken, welche vorteilhaft auf einen speziellen Markt hin angepasst werden können. Die mit den elektrischen Bauelementen bestückte Bestückungsseite der TCU-Leiterplatte weist einen inneren ersten Bereich auf, der von der Abdeckung abgedeckt ist, und einen äußeren zweiten Bereich, der nicht von der Abdeckung abgedeckt ist. In dem äußeren zweiten Bereich sind Kontaktstellen zur elektrischen Kontaktierung der TCU-Leiterplatte angeordnet sein. Die aus TCU-Leiterplatte, elektrischer Schaltung und Abdeckung bestehende TCU-Baugruppe kann über die Kontaktstellen in einfacher Weise mit dem Leiterbahnsubstrat kontaktiert werden.

Ein weiterer Vorteil resultiert daraus, dass die TCU-Baugruppe getrennt von dem gesamten Getriebesteuermodul geprüft werden kann, so dass bei einem in der Fertigung festgestellten Defekt der TCU-Baugruppe nicht das gesamte Getriebesteuermodul verschrottet werden muss.

Neben den Vorteilen in der Fertigung entfällt mit der erfindungsgemäßen Lösung die Notwendigkeit, eine Dichtung zwischen Leiterbahnsubstrat und Trägerplatte vorsehen zu müssen.

Vorteilhafte Ausführungsformen und Weiterbildungen der Erfindung werden durch die in den abhängigen Ansprüchen genannten Merkmale ermöglicht.

Vorteilhaft kann die Abdeckung ein unter Zwischenlage einer umlaufenden Dichtung auf die TCU-Leiterplatte aufgesetztes Deckelteil oder einen polymeren Schutzauftrag, insbesondere einen Lackauftrag, über den elektrischen Bauelementen der TCU-Leiterplatte umfassen.

Die elektrischen Verbindungsmittel verbinden erfindungsgemäß elektrische Kontaktstellen auf einer von der Trägerplatte abgewandten Bestückungsseite der TCU-Leiterplatte mit elektrischen Kontaktstellen auf einer von der Trägerplatte abgewandten Seite des Leiterbahnsubstrats. Dabei können die elektrischen Verbindungsmittel beispielsweise in Form von Bonddrähten, flexiblen Leiterfolienstreifen, Flachbandkabeln, Einpresskontakten oder Jumpern oder ähnlichen Verbindungsmitteln ausgebildet sein.

Falls die elektrischen Verbindungsmittel keinen isolierenden Schutzmantel aufweien, können die elektrischen Verbindungsmittel durch eine lokal im Bereich der Verbindungsmittel aufgebrachte Schutzabdeckung vor dem kontaminierendem Medium geschützt werden.

Die elektrischen Verbindungsmittel können in einfacher und preisgünstig herstellbarerer Weise in Form von Bonddrähten ausgebildet werden, die dann mittels eines polymeren Schutzauftrags auf den Bonddrähten und den elektrischen Kontaktstellen des Leiterbahnsubstrats und der TCU-Leiterplatte gegenüber einem kontaminierendem Medium geschützt sind.

Eine andere Ausführungsform sieht vor, dass die elektrischen Verbindungsmittel flexible Leiterfolienstreifen umfassen, welche zwischen isolierende Folien eingebettete elektrische Leiterbahnen aufweisen, die durch Löten oder Schweißen mit den elektrischen Kontaktstellen des Leiterbahnsubstrats und der TCU-Leiterplatte elektrisch kontaktiert sind.

Weiterhin vorteilhaft aus den bereits angeführten Gründen ist ein Verfahren zur Herstellung eines solchen Getriebesteuermodules.

### Kurze Beschreibung der Zeichnungen

Es zeigen
Fig. 1a und Fig. 1b Teile eines aus dem Stand der Technik bekannten Getriebesteuermoduls im getrennten und zusammengebauten Zustand,
Fig. 2a ein erstes Ausführungsbeispiel eines Herstellungsschritts eines erfindungsgemäßen Getriebesteuermoduls mit einer vom Modul getrennten TCU-Baugruppe,
Fig. 2b die an dem Getriebesteuermodul fertig montierte TCU-Baugruppe auf Fig. 2a,
Fig. 2c das mit elektrischen Komponenten, wie Steckern, Aktuatoren oder Sensoren bestückte fertige Getriebesteuermodul auf Fig. 2b,
Fig. 3a und 3b vergrößerte Ausschnitte aus Fig. 2c für unterschiedliche Ausführungsformen der elektrischen Verbindungsmittel,
Fig. 4 ein zweites Ausführungsbeispiel des Getriebesteuermoduls,
Fig. 5 ein drittes Ausführungsbeispiel des Getriebesteuermoduls,
Fig. 6 einen Verfahrensablauf des Herstellverfahrens des erfindungsgemäßen Getriebesteuermoduls.

### Ausführungsformen der Erfindung

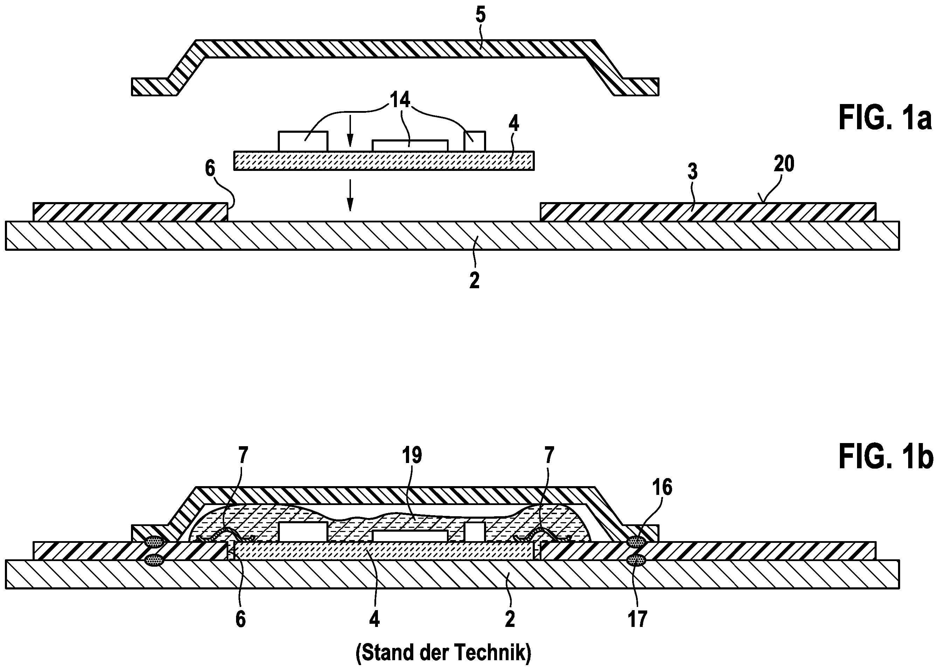

Fig. 1a zeigt den Aufbau eines aus dem Stand der Technik bekannten Getriebesteuermoduls. Das Getriebesteuermodul weist eine Trägerplatte 2 aus beispielsweise Aluminium auf. Auf die Trägerplatte 2 ist ein Leiterbahnsubstrat 3, beispielsweise eine flexible Leiterbahnfolie, bzw. Flexfoil oder eine starre Leiterplatte aufgebracht, beispielweise aufgeklebt. Hierzu wird ein Dichtkleber 17 verwandt werden, wie in Fig. 1b dargestellt ist. Das Leiterbahnsubstrat 3 weist eine durchgehende Ausnehmung 6 auf. Durchgehende Ausnehmung bedeutet, dass die Ausnehmung in dem Leiterbahnsubstrat von der von dem Trägerplatte 2 abgewandten Seite 20 bis zu der der Trägerplatte 2 zugewandten Seite hindurchgeführt ist. Der Dichtkleber 17 verhindert eine Ausbreitung von Hydraulikfluid über einen Spalt zwischen Leiterbahnsubstrat 3 und Trägerplatte 2 bis zur der Ausnehmung 6. Eine TCU-Leiterplatte (TCU = Transmission Control Unit) ist mit elektrischen Bauelementen 14 bestückt, die eine elektrische Steuerschaltung zur Ansteuerung von nicht dargestellten elektrischen Komponenten des Getriebesteuermoduls wie Aktuatoren, Sensoren und anderen bilden. Im Stand der Technik besteht die TCU-Leiterplatte beispielsweise aus einem keramischen Substrat, einem LTCC (Low Temperture Cofired Ceramics). Die TCU-Leiterplatte kann Leiterbahnen in unterschiedlichen Ebenen aufweisen, die über Zwischenverbinder, sogenannte VIAs, die manchmal auch einfach als Durchkontaktierung bezeichnet werden, miteinander verbunden sind. Die elektrischen Bauelemente 14 umfassen auch sogenannte bare-die-Bauelemente, das sind ungehäuste Halbleiterbauelemente. Die Bauelemente 14 können über nicht dargestellte Bonddrähte mit den Leiterbahnen der TCU-Leiterplatte 4 verbunden sein. Die TCU-Leiterplatte 4, wird wie in Fig. 1 a gezeigt, in der Ausnehmung 6 des Leiterbahnsubstrat eingesetzt und auf die Trägerplatte 2 aufgebracht, was beispielsweise durch Kleben erfolgt. Anschließend werden elektrische Verbindungen zwischen Kontaktstellen auf der Bestückungsseite der TCU-Leiterplatte und Kontaktstellen auf der von der Trägerplatte 2 abgewandten Seite des Leiterbahnsubstrats hergestellt. Die dafür verwandten elektrischer Verbindungsmittel 7 sind als Bonddrahtverbindungen ausgebildet. Schließlich wird eine Abdeckung 5, die als Deckel ausgebildet ist, auf das Leiterbahnsubstrat 3 aufgesetzt und über einen dichtenden Kleber 16 mit dem Leiterbahnsubstrat 3 fest verbunden. Anstelle des dichtenden Klebers 16, ist es auch bekannt, Deckelteile unter Zwischenlage eines Dichtrings aufzupressen und über Schrauben oder Nieten oder ähnliches an dem Leiterbahnsubstrat 3 und/oder der Trägerplatte 2 zu befestigen. In dem so gebildeten Gehäuse ist die TCU-Leiterplatte 4 mit den elektrischen Bauelementen 14 zwischen der Trägerplatte 2 und dem Deckelteil 5 geschützt angeordnet. Zusätzlich kann beispielsweise ein Gel 19 durch eine nicht dargestellte Öffnung in den Gehäuseinnenraum oder vor Aufsetzen des Deckels appliziert werden. Das Gel 19 bedeckt die TCU-Leiterplatte, die Verbindungsmittel 7 und denjenigen Teil des Leiterbahnsubstrats 3, der in dem Gehäuseinnenraum angeordnet ist.

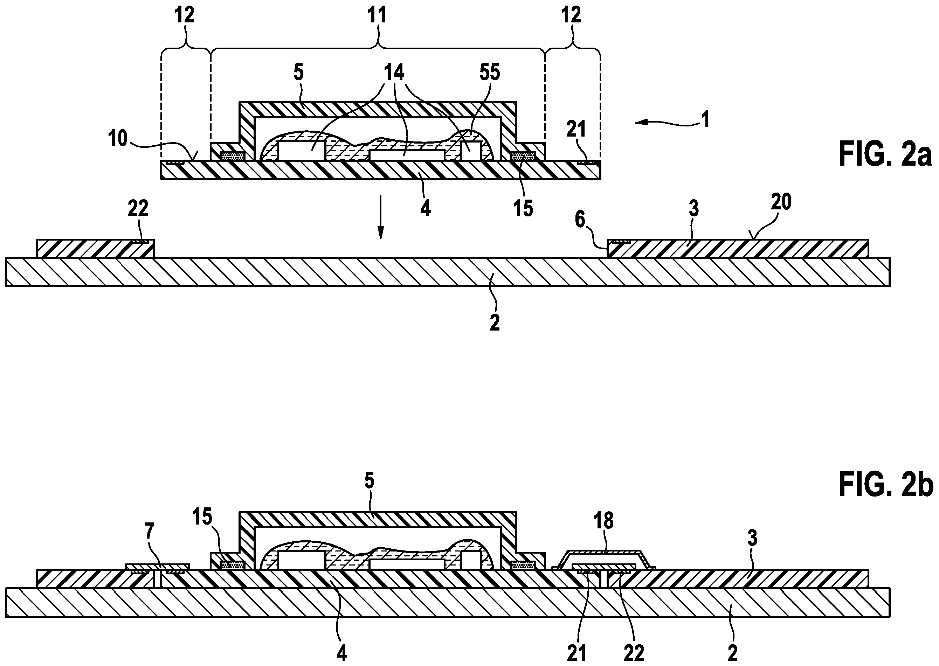

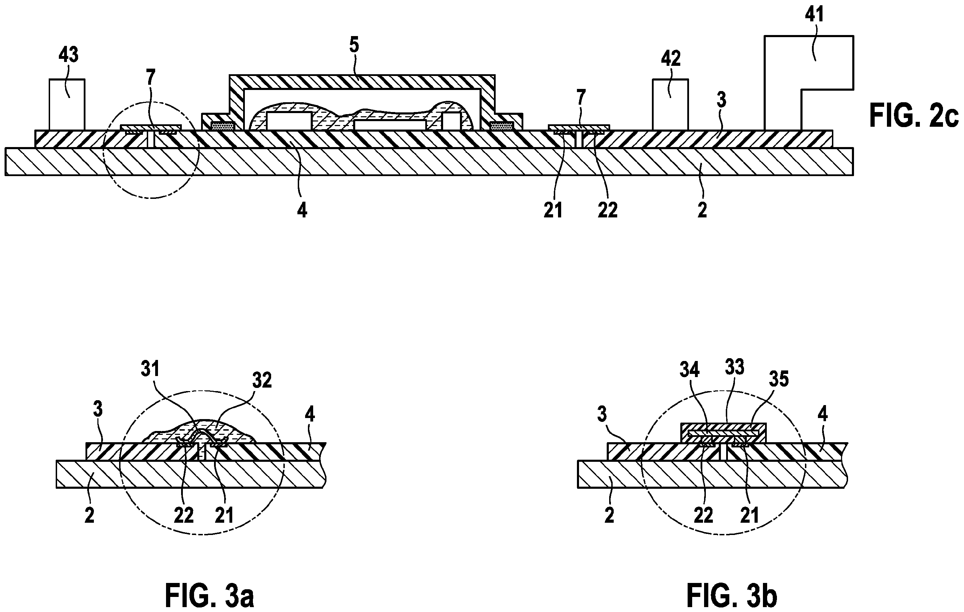

Fig. 2a, Fig. 2b und Fig. 2c zeigen ein erstes Ausführungsbeispiel eines erfindungsgemäßen Getriebesteuermoduls. In Fig. 2a wird ein Herstellungsschritt während der Herstellung des Getriebesteuermoduls 2 gezeigt. Wie zu erkennen ist, wird eine vorgefertigte TCU-Baugruppe 1 verwandt, die mit einer TCU-Leiterplatte 4 in die Aussparung 6 eines Leiterbahnsubstrats 3 auf eine Trägerplatte 2 montiert wird. Die TCU-Baugruppe 1 umfasst eine TCU-Leiterplatte 4. Bei der TCU-Leiterplatte 4 kann es sich beispielsweise um ein LTCC-Substrat oder eine HDI-Leiterplatte handeln.

Eine HDI-Leiterplatte (High-Density-Interconnection Technology) unterscheidet sich von einer herkömmlichen Leiterplatte durch eine sehr hohe Verdrahtungsdichte in Verbindung mit einer hohen Anzahl von sogenannten Microvia-Verbindungen zwischen Leiterbahnen unterschiedlicher Lage. Von einer HDI-Leiterplatte spricht man bei Leiterbahnstrukturen (Breite oder Abstand der Leiterbahnen) von weniger als 150µm, sowie Microvia-Verbindungen mit einem Durchmesser von schon weniger als 0,2mm, typischerweise aber weniger als 0,15mm. Wie die meisten Leiterplatten können HDI-Leiterplatten Leiterbahnen auf mehreren parallel zueinander angeordneten Lagen aufweisen. Neben oder alternativ zu den beiden Außenlagen auf den äußeren Flächen der HDI-Leiterplatte zählen dazu auch innere Lagen. Microvia sind Verbindungen von Leiterbahnen unterschiedlicher Lage der HDI-Leiterplatte. Hierzu zählen Verbindungen von Leiterbahnen der Außenlage mit Leiterbahnen einer inneren Lage, die nicht die nächstliegende innere Lage zu sein braucht und auch eine übernächste oder eine entferntere Innenlage sein kann, ebenso wie von außen nicht sichtbare Verbindungen von Leiterbahnen zweier Innenlagen, die auch als "buried Via" bezeichnet werden, da sie nicht bis zur Außenseite hindurchgeführt sind. Desweiteren besteht auch bei HDI-Leiterplatten die Möglichkeit einer Durchkontaktierung, welche die äußeren beiden voneinander abgewandten Seiten der HDI-Leiterplatte verbindet und Ankontaktierungen an Leiterbahnen auf den Außenlagen und/oder einer oder mehrerer der innen Lagen aufweist. HDI-Leiterplatten sind seit Ende der 90er Jahre vor allem aus Produkten im Mobilfunk-Bereich bekannt.

Die TCU-Leiterplatte 4 ist auf einer Bestückungsseite 10 mit elektrischen Bauelementen 14 durch beispielweise Bonden, Löten, Reflowlöten, Dampfphasenlöten oder Kleben bestückt. Wenigstens bei einigen dieser elektrischen Bauelemente 14 kann es sich um bare-die Halbleiterbauelemente handeln. Die elektrischen Bauelemente 14 sind beispielsweise über Bonddrähte oder Lötverbindungen mit Leiterbahnen auf der TCU-Leiterplatte verbunden und bilden derart eine Steuerschaltung. Auf der Bestückungsseite 10 ist ein innerer erster Bereich 11 zur Anordnung einer Abdeckung 5 vorgehen. Die Abdeckung wird im dargestellten Ausführungsbeispiel beispielsweise durch ein Deckelteil aus Metall oder Kunststoff gebildet. Die Abdeckung 5 wird auf die Bestückungsseite 10 der TCU-Leiterplatte 4 dicht aufgesetzt und daran dauerhaft festgelegt. Zuvor kann die Deckelfügestelle mit Plasma gereinigt werden. Außerdem kann die Deckelfügestelle mit einem Laser strukturiert werden, um einen besseren Halt der Abdeckung 5 zu ermöglichen. Die Abdeckung kann beispielsweise mit einer umlaufenden Dichtklebung 15 an der TCU-Leiterplatte befestigt werden. Alternativ kann die Abdeckung 5 unter Zwischenlage eines Dichtungsrings auf die Bestückungsseite 10 gepresst und dann mittels hier nicht gezeigter Befestigungsmittel daran befestigt werden. Eine weitere Möglichkeit besteht im Aufschmelzen eines Kunststoff-Deckelteils auf das Leiterbahnsubstrat, beispielweise mittels Laserdurchlichtschweißen.

Außerhalb des mit der Abdeckung 5 abgedeckten inneren ersten Bereichs 11 weist die TCU-Leiterplatte 4 einen äußeren zweiten Bereich 12 auf. In diesem äußeren zweiten Bereich 12 sind Kontaktstellen 21 in Form von Anschlusspads vorgesehen, welche mit den Leiterbahnen der TCU-Leiterplatte verbunden sind und welche zur Kontaktierung der elektrischen Schaltung auf der TCU-Leiterplatte 4 dienen. Weiterhin können die Bauelemente 14 unterhalb der Abdeckung 5 durch eine zusätzliche Maßnahme geschützt werden. Hierzu kann es beispielsweise vorgesehen sein, einen Gelauftrag 55 auf die Bauelemente 14 aufzutragen. Dies kann nach der Aufbringung der Abdeckung 5 durch eine verschließbare Öffnung in der Abdeckung 5 erfolgen. Vorzugsweise wird der Gelauftrag 55 jedoch vor der Auftragung der Abdeckung 5 vorgenommen und beschränkt sich auf die elektrischen Bauelemente 14 und ihre Anschlüsse, während der Befestigungsbereich der Abdeckung 5 vom Gelauftrag 55 ausgenommen bleibt.

Die fertige TCU-Baugruppe 1 kann an einen anderen Fertigungsstandort geliefert werden. Unabhängig von der Herstellung der TCU-Baugruppe 1 kann an dem andere Fertigungsstandort die Trägerplatte 2 aus beispielsweise Aluminium mit einem Leiterbahnsubstrat, beispielsweise einer flexiblen Leiterbahnfolie oder einer starren Leiterplatte belegt werden. Im Vergleich zur Fig. 1b kann der Dichtkleber 17 entfallen. Das Leiterbahnsubstrat 3 kann an der Trägerplatte 2 festgerastet oder festgenietet werden. Das Leiterbahnsubstrat kann eine Leiterbahnstruktur aufweisen, die grober ausgeführt ist, als diejenige der TCU-Leiterplatte. Insbesondere kommt die Verwendung einer konventionellen Leiterplatte FR4 oder höherwertig (PCB, printed circuit board) in Betracht, welche aus glasfaserverstärkten Epoxidharz besteht und Leiterbahnen aus Kupfer vorzugsweise auf den inneren Lagen aufweist. Das Leiterbahnsubstrat 3 weist eine durchgehende Ausnehmung 6 auf, deren Innenwandung vorzugsweise umlaufend geschlossen ausgebildet ist. Im Randbereich der Ausnehmung 6 sind Kontaktstellen 22 auf der von der Trägerplatte 2 abgewandten Seite des Leiterbahnsubstrats 3 vorgesehen. Die Kontaktstellen 22 können insbesondere mit Durchkontaktierungen des Leiterbahnsubstrats 2 elektrisch kontaktiert sein. Wie in Fig. 2a gezeigt wird die TCU-Baugruppe 1 mit der TCU-Leiterplatte 4 in der Ausnehmung 6 auf die Trägerplatte 2 aufgebracht. Die Befestigung der TCU-Leiterplatte 4 an der Trägerplatte 2 kann durch Kleben erfolgen, wobei vorteilhaft ein Wärmeleitkleber verwandt wird. Auch andere Befestigungen wir Schrauben oder Nieten oder ähnliches sind möglich.

Wie in Fig. 2b gezeigt ist, werden elektrische Verbindungsmittel 7 hergestellt, welche die TCU-Leiterplatte 4 außerhalb des von der Abdeckung 5 geschützten Bereichs mit dem Leiterbahnsubstrat 3 verbinden. Die Verbindungsmittel 7 können durch eine lokal im Bereich der Verbindungsmittel aufgebrachte Schutzabdeckung 18 vor dem kontaminierendem Medium geschützt werden.

Fig. 2c zeigt, dass außerdem noch vor oder nach der Montage der TCU-Baugruppe 1 weitere elektrische Komponenten 41, 42, 43, wie beispielsweise Stecker 41, Sensoren 42 oder Aktuatoren 42 auf das Leiterbahnsubstrat 3 und/oder die Trägerplatte 2 aufgebracht und in bekannter Weise elektrisch mit dem Leiterbahnsubstrat 3 kontaktiert werden, beispielsweise durch Schweißen oder Löten.

Details der elektrischen Verbindungsmittel 7 sind in Fig. 3a und Fig. 3b dargestellt. In Fig. 3a ist eine Ausführungsform gezeigt, bei der als elektrische Verbindungsmittel 7 Bonddrähte 31 verwandt werden, die jeweils eine elektrische Kontaktstelle 21 der TCU-Leiterplatte 4 mit einer elektrischen Kontaktstelle 22 des Leiterbahnsubstrats 3 verbinden. Ein polymerer Schutzauftrag 32 (beispielsweise ein Lack oder eine Schutzmasse) auf den Bonddrähten 31 und den elektrischen Kontaktstellen 22 des Leiterbahnsubstrats 3 und den elektrischen Kontaktstellen 21 der TCU-Leiterplatte 4 schützt die Bonddrähte 3 gegenüber dem kontaminierendem Medium.

Fig. 3b zeigt eine Ausführungsform bei der die elektrischen Verbindungsmittel 7 flexible Leiterfolienstreifen 33 umfassen, welche zwischen isolierende Folien 35 eingebettete elektrische Leiterbahnen 34 aufweisen, die durch Löten oder Schweißen mit den elektrischen Kontaktstellen 21, 22 des Leiterbahnsubstrats 3 und der TCU-Leiterplatte 4 elektrisch kontaktiert sind. Die flexiblen Leiterfolienstreifen 33 können eine oder gleich mehrere der Leiterbahnen aufweisen, so dass gleich eine Vielzahl von Kontaktstellen 21 mit einer Vielzahl von Kontaktstellen 22 simultan kontaktiert werden kann, wobei jedem Paar von Kontaktstellen 21, 22 vorzugsweise genau eine Leiterbahn 34 zugeordnet ist. Der Vorteil dieser Ausführungsform ist, dass die isolierenden Folien 35 gleichzeitig auch die Kontaktstellen 21, 22 abdecken. Gegebenenfalls kann die isolierende Folie 35 mit ihrer der Trägerplatte 2 gewandten Seite auf die TCU-Leiterplatte und das Leiterbahnsubstrat 3 in der Umgebung der Kontaktstellen 21, 22 aufgeklebt werden, so dass die Kontaktstellen sicher geschützt sind.

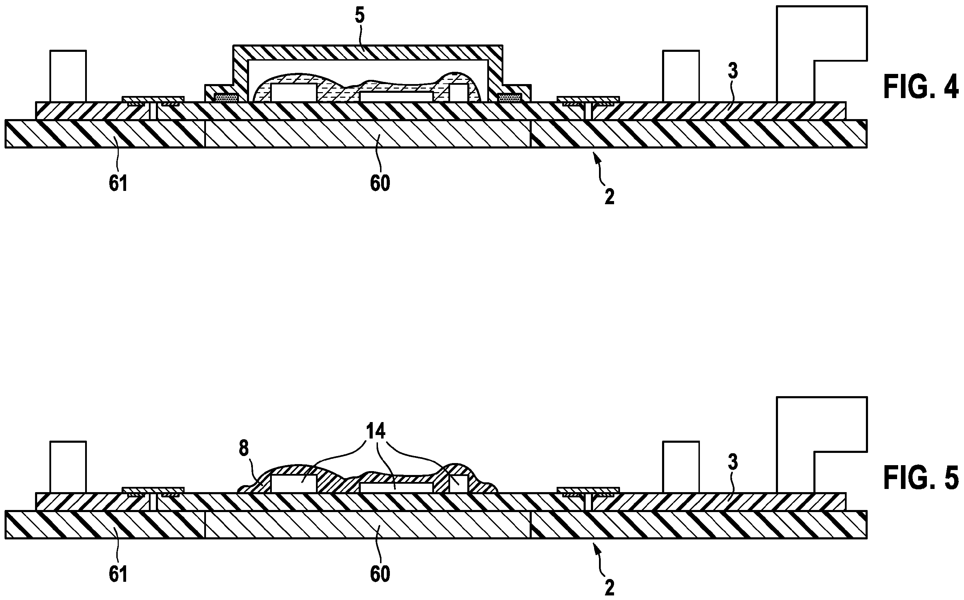

Fig. 4 zeigt ein zweites Ausführungsbeispiel des erfindungsgemäßen Getriebesteuermoduls, welches sich von dem Ausführungsbeispiel aus Fig. 2c nur dadurch unterscheidet, dass die Trägerplatte 2 durch ein Verbundteil aus einer Kunststoffträgerplatte 61, in die eine wärmeleitende Metallplatte 60 eingelassen ist, gebildet wird.

Fig. 5 zeigt ein drittes Ausführungsbeispiel bei dem neben dem Trägerplatten-Verbundteil aus Kunststoffträgerplatte 61 und Metallplatte 60 außerdem eine im Vergleich zu Fig. 2c andersartige Abdeckung 8 verwandt wird. An der Stelle des in Fig. 2c gezeigten Deckelteils wird ein polymeres Schutzsystem verwandt. Hierzu wird eine polymere Schutzmasse auf die TCU-Leiterplatte 4 aufgetragen. Diese kann beispielsweise aus einem Lack bestehen, also einem flüssigen Beschichtungsstoff, der dünn aufgetragen wird und durch chemische oder physikalische Vorgänge (zum Beispiel Verdampfen eines Lösungsmittels) zu einem durchgehenden, festen Film aufgebaut wird. Auch hier können vor der Lackauftrag die für die Auftragung vorgesehenen Stellen auf der TCU-Leiterplatte zuvor mit Plasma gereinigt und gegebenenfalls mit einem Laser strukturiert werden, um einen besseren Halt der Abdeckung 8 zu ermöglichen.

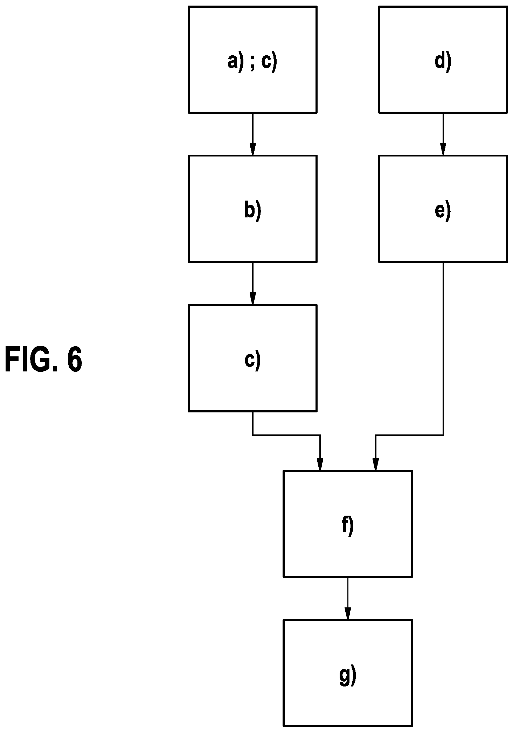

Fig. 6 zeigt ein Ausführungsbeispiel eines Verfahrens zur Herstellung des erfindungsgemäßen Getriebesteuermodules für den Einsatz in einem kontaminierenden Medium. Die Schritte a) bis c) betreffen die Herstellung einer TCU-Baugruppe 1. Dabei wird in einem ersten Schritt a) eine TCU-Leiterplatte 4 mit elektrischen Bauelementen 14 einer Steuerschaltung bestückt. In einem zweiten Schritt b) wird eine Abdeckung 5, 8 zum gemeinsamen Schutz der auf der TCU-Leiterplatte 4 angeordneten elektrischen Bauelemente 14 an der TCU-Leiterplatte dicht angeordnet und befestigt, wobei eine mit den elektrischen Bauelementen 14 bestückte Bestückungsseite 10 der TCU-Leiterplatte 4 einen inneren ersten Bereich 11 aufweist, der von der Abdeckung 5, 8 dicht abgedeckt ist, und einen äußeren zweiten Bereich 12 aufweist, der nicht von der Abdeckung 5, 8 abgedeckt ist. Im Schritt c) werden Kontaktstellen 21 zur Kontaktierung der Modulleiterplatte 4 in dem äußeren zweiten Bereich 10 ausgebildet. Der Schritt c) kann selbstverständlich auch zusammen mit dem Schritt a) und vor dem Schritt b) durchgeführt werden. Unabhängig von der Herstellung der TCU-Baugruppe 1 kann in einem Verfahrensschritt d) eine Trägerplatte bereitgestellt werden und in einem Schritt e) ein Leiterbahnsubstrat 3, das eine durchgehend Ausnehmung 6 aufweist, auf der Trägerplatte 2 angeordnet werden. Wie in Fig. 6 dargestellt, wird sodann in einem Schritt f) die TCU-Leiterplatte 4 der TCU-Baugruppe 1 in die durchgehende Aussparung 6 des Leiterbahnsubstrats 3 eingesetzt und auf die Trägerplatte 2 aufgebracht und in einem Schritt g) elektrische Verbindungsmitteln 7 hergestellt, welche die TCU-Leiterplatte 4 mit dem Leiterbahnsubstrat 3 elektrisch kontaktieren.

## Patentansprüche

1. Getriebesteuermodul für den Einsatz in einem kontaminierenden Medium, aufweisend:
- eine Trägerplatte (2)
- ein Leiterbahnsubstrat (3), das auf der Trägerplatte (2) angeordnet ist und eine durchgehende Ausnehmung (6) aufweist,
- eine TCU-Leiterplatte (4), die mit elektrischen Bauelementen (14) einer Steuerschaltung bestückt ist und die in die Aussparung (6) des Leiterbahnsubstrats (3) eingesetzt und auf die Trägerplatte (2) aufgebracht ist,
- elektrische Verbindungsmittel (7), welche die TCU-Leiterplatte (4) mit dem Leiterbahnsubstrat (3) elektrisch kontaktieren,
- und eine Abdeckung (5, 8, 16) zum gemeinsamen Schutz der auf der TCU-Leiterplatte (4) angeordneten elektrischen Bauelemente (14),
wobei die Abdeckung (5, 8) ausschließlich auf der TCU-Leiterplatte dicht angeordnet und befestigt ist,
wobei eine mit den elektrischen Bauelementen (14) bestückte Bestückungsseite (10) der TCU-Leiterplatte (4) einen inneren ersten Bereich (11) aufweist, der von der Abdeckung (5, 8) abgedeckt ist, und einen äußeren zweiten Bereich (12) aufweist, der nicht von der Abdeckung (5, 8) abgedeckt ist, und dass in dem äußeren zweiten Bereich (12) Kontaktstellen (21) zur elektrischen Kontaktierung der TCU-Leiterplatte (4) angeordnet sind, wobei die elektrischen Verbindungsmittel (7) die elektrische Kontaktstellen (21) auf einer von der Trägerplatte (2) abgewandten Bestückungsseite (10) der TCU-Leiterplatte (4) mit elektrischen Kontaktstellen (22) auf einer von der Trägerplatte (2) abgewandten Seite (20) des Leiterbahnsubstrats (3) verbinden.

2. Getriebesteuermodul nach Anspruch 1, **dadurch gekennzeichnet, dass** die Abdeckung (5, 8) ein unter Zwischenlage einer umlaufenden Dichtung (15) auf die TCU-Leiterplatte (4) aufgesetztes Deckelteil (5) oder einen polymeren Schutzauftrag (8), insbesondere einen Lackauftrag, über den elektrischen Bauelementen (14) der TCU-Leiterplatte (4) umfasst.

3. Getriebesteuermodul nach Anspruch 1 oder Anspruch 2, **dadurch gekennzeichnet, dass** die elektrischen Verbindungsmittel (7) in Form von Bonddrähten, flexiblen Leiterfolienstreifen, Flachbandkabeln, Einpresskontakten, Jumpern oder ähnlichen Verbindungsmitteln ausgebildet sind.

4. Getriebesteuermodul nach Anspruch 1 oder 3, **dadurch gekennzeichnet, dass** die elektrischen Verbindungsmittel (7) durch eine lokal im Bereich der Verbindungsmittel aufgebrachte Schutzabdeckung (18) vor dem kontaminierendem Medium geschützt sind.

5. Getriebesteuermodul nach Anspruch 1, **dadurch gekennzeichnet, dass** die elektrischen Verbindungsmittel (7) in Form von Bonddrähten (31) ausgebildet sind, die mittels eines polymeren Schutzauftrags (32) auf den Bonddrähten (31) und den elektrischen Kontaktstellen (21, 22) des Leiterbahnsubstrats (3) und der TCU-Leiterplatte (4) gegenüber einem kontaminierendem Medium geschützt sind.

6. Getriebesteuermodul nach Anspruch 1, **dadurch gekennzeichnet, dass** die elektrischen Verbindungsmittel (7) flexible Leiterfolienstreifen (33) umfassen, welche zwischen isolierende Folien (35) eingebettete elektrische Leiterbahnen (34) aufweisen, die durch Löten oder Schweißen mit den elektrischen Kontaktstellen (21, 22) des Leiterbahnsubstrats (3) und der TCU-Leiterplatte (4) elektrisch kontaktiert sind.

7. Getriebesteuermodul nach Anspruch 1, **dadurch gekennzeichnet, dass** die TCU-Leiterplatte eine HDI-Leiterplatte ist.

8. Verfahren zur Herstellung eines Getriebesteuermodules nach Anspruch 1, umfassend folgende Schritte:
- Herstellen einer TCU-Baugruppe (1) durch die nachfolgend angeführten Schritte a) bis c):
a) Bestücken einer TCU-Leiterplatte (4) mit elektrischen Bauelementen (14) einer Steuerschaltung,
b) Anordnen und Befestigen einer Abdeckung (5, 8) an der TCU-Leiterplatte (4) zum gemeinsamen Schutz der auf der TCU-Leiterplatte (4) angeordneten elektrischen Bauelemente (14), wobei eine mit den elektrischen Bauelementen (14) bestückte Bestückungsseite (10) der TCU-Leiterplatte (4) einen inneren ersten Bereich (11) aufweist, der von der Abdeckung (5, 8) dicht abgedeckt ist, und einen äußeren zweiten Bereich (12) aufweist, der nicht von der Abdeckung (5, 8) abgedeckt ist, und
c) Vorsehen von Kontaktstellen (21) zur Kontaktierung der Modulleiterplatte (4) in dem äußeren zweiten Bereich (10),
- wobei das Verfahren die folgenden, unabhängig von der Herstellung der TCU-Baugruppe (1) durchzuführenden Schritte d) und e) aufweist:
d) Bereitstellen einer Trägerplatte (2) sowie
e) Anordnen eines Leiterbahnsubstrats (3), das eine durchgehend Ausnehmung (6) aufweist, auf der Trägerplatte (2),
- und wobei das Verfahren weiterhin die folgenden Montageschritte f) und g) aufweist:
f) Einsetzen der TCU-Leiterplatte (4) der TCU-Baugruppe (1) in die durchgehende Aussparung (6) des Leiterbahnsubstrats (3) auf die Trägerplatte (2) und
g) Herstellen von elektrischen Verbindungsmitteln (7), welche die TCU-Leiterplatte (4) mit dem Leiterbahnsubstrat (3) elektrisch kontaktieren.

## Claims

1. Transmission control module for use in a contaminating medium, comprising:
- a carrier plate (2),
- a conductor track substrate (3), which is arranged on the carrier plate (2) and has a continuous recess (6),
- a TCU circuit board (4), which is populated with electrical components (14) of a control circuit and which is inserted into the cut-out (6) of the conductor track substrate (3) and is applied to the carrier plate (2),
- electrical connection means (7), which electrically contact-connect the TCU circuit board (4) to the conductor track substrate (3),
- and a cover (5, 8, 16) for common protection of the electrical components (14) arranged on the TCU circuit board (4),
wherein the cover (5, 8) is arranged in a sealed manner and fastened exclusively on the TCU circuit board,
wherein a populating side (10) of the TCU circuit board (4) populated with the electrical components (14) has an inner first region (11), which is covered by the cover (5, 8), and an outer second region (12), which is not covered by the cover (5, 8), and contact points (21) for the electrical contact-connection of the TCU circuit board (4) are arranged in the outer second region (12), wherein the electrical connection means (7) connect the electrical contact points (21) on a populating side (10) of the TCU circuit board (4) facing away from the carrier plate (2) to electrical contact points (22) on a side (20) of the conductor track substrate (3) facing away from the carrier plate (2).

2. Transmission control module according to Claim 1, **characterized in that** the cover (5, 8) comprises a cover part (5), fitted to the TCU circuit board (4) with a surrounding seal (15) in between, or a polymeric protective coating (8), in particular a lacquer coating, above the electrical components (14) of the TCU circuit board (4).

3. Transmission control module according to Claim 1 or Claim 2, **characterized in that** the electrical connection means (7) are designed in the form of bonding wires, flexible conductor film strips, flat ribbon cables, press-in contacts, jumpers or similar connection means.

4. Transmission control module according to Claim 1 or 3, **characterized in that** the electrical connection means (7) are protected from the contaminating medium by way of a protective cover (18) applied in the region of the connection means.

5. Transmission control module according to Claim 1, **characterized in that** the electrical connection means (7) are designed in the form of bonding wires (31), which are protected from a contaminating medium by means of a polymeric protective coating (32) on the bonding wires (31) and the electrical contact points (21, 22) of the conductor track substrate (3) and the TCU circuit board (4) .

6. Transmission control module according to Claim 1, **characterized in that** the electrical connection means (7) comprise flexible conductor film strips (33), which have electrical conductor tracks (34), which are embedded between insulating films (35) and are electrically contact-connected to the electrical contact points (21, 22) of the conductor track substrate (3) and the TCU circuit board (4) by way of soldering or welding.

7. Transmission control module according to Claim 1, **characterized in that** the TCU circuit board is an HDI circuit board.

8. Method for producing a transmission control module according to Claim 1, comprising the following steps:
- producing a TCU assembly (1) by way of steps a) to c) listed below:
a) populating a TCU circuit board (4) with electrical components (14) of a control circuit,
b) arranging and fastening a cover (5, 8) to the TCU circuit board (4) for common protection of the electrical components (14) arranged on the TCU circuit board (4), wherein a populating side (10) of the TCU circuit board (4) populated with the electrical components (14) has an inner first region (11), which is covered in a sealed manner by the cover (5, 8), and an outer second region (12), which is not covered by the cover (5, 8), and
c) providing contact points (21) for contact-connection of the module circuit board (4) in the outer second region (10),
- wherein the method comprises the following steps d) and e) to be carried out independently of the production of the TCU assembly (1):
d) providing a carrier plate (2) and
e) arranging a conductor track substrate (3), which has a continuous recess (6), on the carrier plate (2),
- and wherein the method furthermore comprises the following assembly steps f) and g):
f) inserting the TCU circuit board (4) of the TCU assembly (1) into the continuous cut-out (6) of the conductor track substrate (3) onto the carrier plate (2) and
g) producing electrical connection means (7), which electrically contact-connect the TCU circuit board (4) to the conductor track substrate (3).

## Revendications

1. Module de commande de transmission pour une utilisation dans un milieu contaminant, présentant :
- une plaque de support (2)
- un substrat de pistes conductrices (3) qui est disposé sur la plaque de support (2) et présente un évidement continu (6),
- une carte de circuits imprimés TCU (4) qui est équipée de composants électriques (14) d'un circuit de commande et qui est insérée dans l'évidement (6) du substrat de pistes conductrices (3) et appliquée sur la plaque de support (2),
- des moyens de connexion électriques (7) qui mettent en contact électrique la carte de circuits imprimés TCU (4) avec le substrat de pistes conductrices (3),
- et un recouvrement (5, 8, 16) pour la protection commune des composants électriques (14) disposés sur la carte de circuits imprimés TCU (4),
le recouvrement (5, 8) étant disposé et fixé de façon étanche exclusivement sur la carte de circuits imprimés TCU,
un côté d'équipement (10) équipé des composants électriques (14) de la carte de circuits imprimés TCU (4) présentant une première zone intérieure (11) qui est recouverte par le recouvrement (5, 8), et présentant une deuxième zone extérieure (12) qui n'est pas recouverte par le recouvrement (5, 8), et dans la deuxième zone extérieure (12) des points de contact (21) étant disposés pour la mise en contact électrique de la carte de circuits imprimés TCU (4), les moyens de connexion électriques (7) reliant les points de contact électriques (21) sur une face d'équipement (10), détournée de la plaque de support (2), de la carte de circuits imprimés TCU (4) à des points de contact électriques (22) sur une face (20), détournée de la plaque de support (2), du substrat de pistes conductrices (3).

2. Module de commande de transmission selon la revendication 1, **caractérisé en ce que** le recouvrement (5, 8) comprend une partie de couvercle (5) posée sur la carte de circuits imprimés TCU (4) avec insertion d'un joint d'étanchéité périphérique (15), ou une couche de protection polymère (8), en particulier une couche de vernis, sur les composants électriques (14) de la carte de circuits imprimés TCU (4).

3. Module de commande de transmission selon la revendication 1 ou la revendication 2, **caractérisé en ce que** les moyens de connexion électriques (7) sont réalisés sous la forme de fils de connexion, de bandes de feuille conductrice flexibles, de câbles plats, de contacts d'insertion, de cavaliers ou de moyens de connexion similaires.

4. Module de commande de transmission selon la revendication 1 ou 3, **caractérisé en ce que** les moyens de connexion électriques (7) sont protégés contre le milieu contaminant par un recouvrement de protection (18) appliqué localement au niveau des moyens de liaison.

5. Module de commande de transmission selon la revendication 1, **caractérisé en ce que** les moyens de connexion électrique (7) sont réalisés sous la forme de fils de connexion (31) qui sont protégés contre un milieu contaminant au moyen d'une couche de protection polymère (32) sur les fils de connexion (31) et les points de contact électriques (21, 22) du substrat de pistes conductrices (3) et de la carte de circuits imprimés TCU (4).

6. Module de commande de transmission selon la revendication 1, **caractérisé en ce que** les moyens de connexion électriques (7) comprennent des bandes de feuille conductrice (33) qui présentent des pistes conductrices électriques (34) incorporées entre des feuilles isolantes (35) et qui sont mises en contact électrique par brasage ou soudage avec les points de contact électriques (21, 22) du substrat de pistes conductrices (3) et de la carte de circuits imprimés TCU (4).

7. Module de commande de transmission selon la revendication 1, **caractérisé en ce que** la carte de circuits imprimés TCU est une carte de circuits imprimés HDI.

8. Procédé de fabrication d'un module de commande de transmission selon la revendication 1, comprenant les étapes suivantes consistant à :
- fabriquer un sous-ensemble TCU (1) par les étapes a) à c) énumérées ci-après :
a) équiper une carte de circuits imprimés TCU (4) de composants électriques (14) d'un circuit de commande,
b) disposer et fixer un recouvrement (5, 8) sur la carte de circuits imprimés TCU (4) pour la protection commune des composants électriques (14) disposés sur la carte de circuits imprimés TCU (4), une face d'équipement (10), équipée des composants électriques (14), de la carte de circuits imprimés TCU (4) présentant une première zone intérieure (11) qui est recouverte de manière étanche par le recouvrement (5, 8), et présentant une deuxième zone extérieure (12) qui n'est pas recouverte par le recouvrement (5, 8), et
c) prévoir des points de contact (21) pour la mise en contact de la carte de circuits imprimés de module (4) dans la deuxième zone extérieure (10),
- le procédé présentant les étapes d) et e) suivantes, à exécuter indépendamment de la fabrication du sous-ensemble TCU (1) :
d) fournir une plaque de support (2), et
e) disposer un substrat de pistes conductrices (3) qui présente un évidement continu (6) sur la plaque de support (2),
- et le procédé présentant en outre les étapes de montage suivantes f) et g) :
f) insérer la carte de circuits imprimés TCU (4) du sous-ensemble TCU (1) dans l'évidement continu (6) du substrat de pistes conductrices (3) sur la plaque de support (2), et
g) fabriquer des moyens de connexion électriques (7) qui mettent en contact électrique la carte de circuits imprimés TCU (4) avec le substrat de pistes conductrices (3).
